(19) Europäisches Patentamt
European Patent Office
Office européen des brevets

(11) **EP 3 203 536 B1**

(12) **EUROPEAN PATENT SPECIFICATION**

(45) Date of publication and mention
of the grant of the patent:
**15.07.2020 Bulletin 2020/29**

(51) Int Cl.:
*H01L 35/22* [(2006.01)]   *B22F 3/14* [(2006.01)]
*B22F 5/00* [(2006.01)]   *C01B 33/06* [(2006.01)]
*C22C 1/04* [(2006.01)]   *C22C 23/00* [(2006.01)]
*C22C 13/00* [(2006.01)]   *C30B 1/02* [(2006.01)]
*C30B 29/52* [(2006.01)]   *C04B 35/58* [(2006.01)]
*C04B 35/645* [(2006.01)]

(21) Application number: **15847992.3**

(22) Date of filing: **18.09.2015**

(86) International application number:
**PCT/JP2015/076748**

(87) International publication number:
**WO 2016/052272 (07.04.2016 Gazette 2016/14)**

(54) **P-TYPE THERMOELECTRIC MATERIAL, THERMOELECTRIC ELEMENT AND METHOD FOR PRODUCING P-TYPE THERMOELECTRIC MATERIAL**

THERMOELEKTRISCHES MATERIAL VOM P-TYP, THERMOELEKTRISCHES ELEMENT UND VERFAHREN ZUR HERSTELLUNG EINES THERMOELEKTRISCHEN MATERIALS VOM P-TYP

MATÉRIAU THERMOÉLECTRIQUE DE TYPE P, ÉLÉMENT THERMOÉLECTRIQUE ET PROCÉDÉ DE PRODUCTION DE MATÉRIAU THERMOÉLECTRIQUE DE TYPE P

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.10.2014 JP 2014205229**

(43) Date of publication of application:
**09.08.2017 Bulletin 2017/32**

(73) Proprietors:
• **Mitsuba Corporation**
  **Kiryu-shi, Gunma 376-8555 (JP)**
• **National Institute for Materials Science**
  **Tsukuba-shi, Ibaraki 305-0047 (JP)**

(72) Inventors:
• **TADA Satoki**
  **Kiryu-shi**
  **Gunma 376-8555 (JP)**
• **ISODA Yukihiro**
  **Tsukuba-shi**
  **Ibaraki 305-0047 (JP)**

(74) Representative: **Cabinet Laurent & Charras**
**Le Contemporain**
**50 Chemin de la Bruyère**
**69574 Dardilly Cedex (FR)**

(56) References cited:
EP-A1- 2 770 069    WO-A1-2010/112956
GB-A- 1 424 011    JP-A- 2008 160 077
JP-A- 2013 197 550    JP-A- 2015 026 672
US-A- 3 782 927

• **S. TADA ET AL: "Preparation and thermoelectric properties of Mg 2 Si 0.9- x Sn x Ge 0.1 : Preparation and thermoelectric properties of Mg 2 Si 0.9- x Sn x Ge 0.1", PHYSICA STATUS SOLIDI. C: CURRENT TOPICS IN SOLID STATE PHYSICS, vol. 10, no. 12, 11 November 2013 (2013-11-11), pages 1704-1707, XP055447663, DE ISSN: 1862-6351, DOI: 10.1002/pssc.201300357**
• **Y. ISODA ET AL: "Thermoelectric Properties of p-Type Mg2.00Si0.25Sn0.75 with Li and Ag Double Doping", JOURNAL OF ELECTRONIC MATERIALS., vol. 39, no. 9, 8 June 2010 (2010-06-08), pages 1531-1535, XP055447684, US ISSN: 0361-5235, DOI: 10.1007/s11664-010-1280-7**
• **GUANGYU JIANG ET AL: "Improving p-type thermoelectric performance of Mg2(Ge,Sn) compounds via solid solution and Ag doping", INTERMETALLICS., vol. 32, 9 October 2012 (2012-10-09), pages 312-317, XP055310989, GB ISSN: 0966-9795, DOI: 10.1016/j.intermet.2012.08.002**

- **ISODA YUKIHIRO ET AL.: 'Thermoelectric Performance of p-Type Mg2Si0.25Sn0.75 with Li and Ag Double Doping' MATERIALS TRANSACTIONS vol. 51, no. 5, 01 January 2010, pages 868 - 871, XP055424857 DOI: 10.2320/MATERTRANS.MH200906**
- **FEDOROV, M.I. ET AL.: 'Transport properties of Mg2X0.4Sn0.6 solid solutions (X=Si,Ge) with p-type conductivity' PHYSICS OF THE SOLID STATE vol. 48, no. 8, 01 August 2006, pages 1486 - 1490, XP019412662 DOI: 10.1134/S1063783406080117**
- **Aesar Alfa: "Certificate of Analysis Mg 3N", , 2 August 2016 (2016-08-02), XP055593433, Retrieved from the Internet: URL:https://cz.vwr.com/assetsvc/asset/cs_C Z/id/20752342/contents [retrieved on 2019-06-03]**
- **Aesar Alfa: "Certificate of Analysis Sn 5N", , 27 June 2012 (2012-06-27), XP055593434, Retrieved from the Internet: URL:https://cz.vwr.com/assetsvc/asset/cs_C Z/id/18866700/contents [retrieved on 2019-06-03]**
- **Aesar Alfa: "Certificate of Analysis Si 6N", , 19 September 2012 (2012-09-19), XP055593437, Retrieved from the Internet: URL:https://cz.vwr.com/assetsvc/asset/cs_C Z/id/20750226/contents [retrieved on 2019-06-03]**
- **Aesar Alfa: "Certificate of Analysis Ag 4N", , 15 September 2011 (2011-09-15), XP055593439, Retrieved from the Internet: URL:https://cz.vwr.com/assetsvc/asset/cs_C Z/id/18881660/contents [retrieved on 2019-06-03]**

## Description

[Technical Field]

The present invention relates to a p-type thermoelectric material, a thermoelectric element and a method for producing a p-type thermoelectric material.

[Background Art]

In recent years, thermoelectric conversion for converting thermal energy and electric energy by utilizing the Seebeck effect and Peltier effect has been attracting attention as a technology for utilizing energy highly efficiently.

For thermoelectric conversion, a thermoelectric material which is a material capable of converting thermal energy and electric energy to each other is used.

As a thermoelectric material, Mg-Si-Sn-based, Bi-Te-based and Pb-Te-based materials, and the like have been known (for example, see Japanese Unexamined Patent Application First Publication No. 2005-133202).

Bi-Te-based and Pb-Te-based materials are expensive and also require careful handling because they use highly rare and hazardous elements. On the other hand, Mg-Si-Sn based materials are excellent in terms of cost and safety because they do not use highly rare and hazardous elements.

Although the Mg-Si-Sn based thermoelectric materials are often used as n-type thermoelectric materials, they have been reported to exhibit p-type characteristics depending on their compositions (for example, see Japanese Patent No. 5274146 and Japanese Unexamined Patent Application, First Publication No. 2011-151329).

Document of Tada et al; "Preparation and thermoelectric properties of Mg2Si0.9-xSnxGe0.1", PHYSICA STATUS SOLIDI. C 10, No. 12, 1704-1707 (2013). discloses a p-type thermoelectric material with formula Mg2Si0.25Sn0.65Ge0.10 in which the 3N Mg has unavoidable impurities which amount is at most about several ppm.

Document of Y.Isoda et al; "Thermoelectric Properties of p-Type Mg2.00Si0.25Sn0.75 with Li and Ag Double Doping", Journal of ELECTRONIC MATERIALS, Vol. 39,No. 9, 2010, 1531-1535, and document of Guangyu Jiang et al; "Improving p-type thermoelectric performance of Mg2(Ge,Sn) compounds via solid solution and Ag doping", Intermetallics 32 (2013) 312-317, disclose ternary compounds.

[Summary of Invention]

[Technical Problem]

However, although n-type thermoelectric materials exhibiting high thermoelectric performance have been known, as for p-type thermoelectric materials, their thermoelectric performance has not necessarily been sufficient.

The present invention takes the above circumstances into consideration, with an object of providing a thermoelectric material excellent in performance as a p-type thermoelectric material and a production method thereof.

[Solution to Problem]

As a result of intensive investigations, the inventors of the present invention have found that high thermoelectric performance can be achieved by substituting at least any one of a Mg site, a Si site, a Sn site and/or a Ge site of a compound composed of magnesium (Mg), silicon (Si), tin (Sn) and germanium (Ge) with elements selected from the group consisting of alkali metals of group 1A and gold (Au), silver (Ag), copper (Cu), zinc (Zn), calcium (Ca) and gallium (Ga) of group 1B, thus completing the present invention.

That is, in order to solve the above problems, the present invention adopts the means disclosed in the appended claims.

[Advantageous Effects of Invention]

In the p-type thermoelectric member according to one aspect of the present invention, at least any one of a Mg site, a Si site, a Sn site and/or a Ge site of a compound composed of magnesium (Mg), silicon (Si), tin (Sn) and germanium (Ge) is substituted with elements selected from the group consisting of alkali metals of group 1A and gold (Au), silver (Ag), copper (Cu), zinc (Zn), calcium (Ca) and gallium (Ga) of group 1B. For this reason, high thermoelectric performance can be achieved.

A method for producing a p-type thermoelectric material includes a step of accommodating magnesium (Mg), silicon (Si), tin (Sn), germanium (Ge) and at least any one of the group consisting of alkali metals of group 1A and gold (Au), silver (Ag), copper (Cu), zinc (Zn), calcium (Ca) and gallium (Ga) of group 1B as a substitution element in a heating member; a step of heating the aforementioned heating member to synthesize a solid solution; and a step of pulverizing and further pressurizing and sintering the aforementioned solid solution. According to this method, a thermoelectric material in which at least any one of a Mg site, a Si site, a Sn site and/or a Ge site of a compound composed of magnesium (Mg), silicon (Si), tin (Sn) and germanium (Ge) is substituted with elements selected from the group consisting of alkali metals of group 1A and gold (Au), silver (Ag), copper (Cu), zinc (Zn), calcium (Ca) and gallium (Ga) of group 1B can be homogeneously produced.

[Brief Description of Drawings]

FIG. 1 shows a crystal structure of a quaternary compound composed of magnesium (Mg), silicon (Si), tin (Sn) and germanium (Ge).
FIG. 2 is a diagram showing regions exhibiting p-type conduction and n-type conduction in a quaternary compound of Mg, Si, Sn and Ge.
FIG. 3 shows a relationship between the compositions of Ge and Si with respect to the conduction types.
FIG. 4 shows a relationship between the compositions of Ge and Sn with respect to the conduction types.
FIG. 5 is a flowchart showing a procedure of a method for producing a thermoelectric material.
FIG. 6 is a schematic view showing a state of installation of raw materials in producing a solid solution.
FIG. 7 shows the X-ray diffraction results of the thermoelectric material of Example 1.
FIG. 8 shows the results of the temperature dependence of the electrical resistivity of the thermoelectric materials of Comparative Examples 2 to 6.
FIG. 9 shows the results of the temperature dependence of the electrical resistivity of the thermoelectric materials of Example 1 and Comparative Example 1.
FIG. 10 shows the temperature dependence of the thermal conductivities of the thermoelectric materials of Comparative Examples 2 to 6.
FIG. 11 shows the results of the temperature dependence of the thermal conductivities of the thermoelectric materials of Example 1 and Comparative Example 1.
FIG. 12 shows the results of the temperature dependence of the Seebeck coefficients of the thermoelectric materials of Comparative Examples 2 to 6.
FIG. 13 shows the results of the temperature dependence of the Seebeck coefficients of the thermoelectric materials of Example 1 and Comparative Example 1.
FIG. 14 shows the results of the temperature dependence of the dimensionless figure of merit ZT of Example 1, Comparative Example 1 and Comparative Example 2.
FIG. 15 shows the results of the temperature dependence of the electrical resistivity of Examples 1 to 4.
FIG. 16 shows the results of the temperature dependence of the Seebeck coefficient of Examples 1 to 4.
FIG. 17 shows the results of the temperature dependence of the thermal conductivity of Examples 1 to 4.
FIG. 18 shows the results of the temperature dependence of the dimensionless figure of merit ZT of Examples 1 to 4.

[Description of Embodiments]

Hereinafter, configurations of the p-type thermoelectric material and the method for producing a p-type thermoelectric material to which the present invention is applied will be described. In the drawings used in the following description, the characteristic portions and components may be enlarged for easier understanding of characteristic features as a matter of convenience, and the dimensional ratio of each constituent element is not necessarily the same as the actual dimensional ratio. Materials, dimensions, and the like illustrated in the following description are merely examples, and the present invention is not limited thereto and can be carried out with appropriate modifications without departing from the invention as defined in the appended claims.

(p-type thermoelectric material)

A p-type thermoelectric material according to one aspect of the present invention is obtained by substituting at least any one of the Mg site, the Si site, the Sn site and/or the Ge site of a compound represented by the following general formula (1) which is composed of magnesium (Mg), silicon (Si), tin (Sn) and germanium (Ge) with elements selected from the group consisting of alkali metals of group 1A and gold (Au), silver (Ag), copper (Cu), zinc (Zn), calcium (Ca) and gallium (Ga) of group 1B:

$$Mg_A(Si_X Sn_Y Ge_Z) \qquad (1)$$

provided that relationships represented by formulas: $1.98 \leq A \leq 2.01$, $0.00 < X \leq 0.25$, $0.60 \leq Y \leq 0.95$, $Z > 0$, $X + Y + Z = 1$ and $-1.00X + 0.40 \geq Z \geq -2.00X + 0.10$ $(0.00 < X \leq 0.25)$, $-1.00Y + 1.00 \geq Z \geq -1.00Y + 0.75$ $(0.60 \leq Y \leq 0.90)$, $-2.00Y + 1.90 \geq Z \geq -1.00Y + 0.75$ $(0.90 < Y \leq 0.95)$ are satisfied.

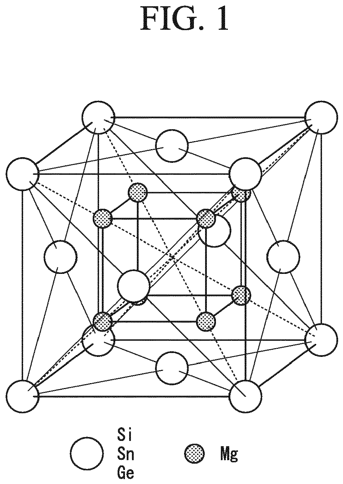

FIG. 1 shows a crystal structure of a quaternary compound composed of magnesium (Mg), silicon (Si), tin (Sn) and germanium (Ge). The compound composed of magnesium (Mg), silicon (Si), tin (Sn) and germanium (Ge) has an inverse fluorite structure.

In the p-type thermoelectric material according to one aspect of the present invention, the compound composed of magnesium (Mg), silicon (Si), tin (Sn) and germanium (Ge) and has this inverse fluorite structure is used as a basic structure. A p-type thermoelectric material composed of a quaternary compound using such four elements is capable of reducing the thermal conductivity as compared with a ternary compound of magnesium (Mg), silicon (Si) and tin (Sn) which has been studied conventionally (Patent Documents 2 and 3).

The reason why the thermal conductivity can be reduced by using the quaternary compound, as compared with the ternary compound, will be described below. As compared with the ternary compound, the quaternary compound contain Ge to increase the number of elements. Given that $Mg_2Si$ or $Mg_2Sn$ has an ideal crystal lattice, replacing a different element therewith is equivalent to introducing a defect thereto. That is, the crystal lattice of the quaternary compound is likely to be disturbed as compared with the ternary compound. In general, the thermal conduction includes thermal conduction by the carriers and thermal conduction by the lattice. In this system, the thermal conduction by the lattice is predominant. For this reason, by employing the quaternary compound, the crystal lattice is disturbed and the thermal conductivity is reduced.

The dimensionless figure of merit ZT of the thermoelectric material is expressed as follows. Here, $\alpha$ represents the Seebeck coefficient, T represents the absolute temperature, $\rho$ represents the electrical resistivity and $\kappa$ represents the thermal conductivity.

$$ZT = \alpha^2 T / \rho \kappa \qquad (2)$$

Therefore, reducing the thermal conductivity by employing the quaternary compound leads to an enhancement of thermoelectric performance.

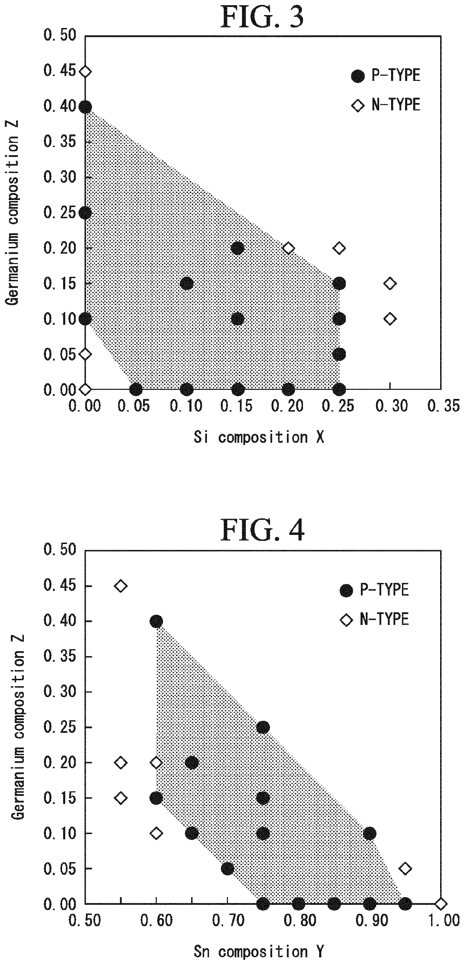

In the compound represented by the above general formula (1), the composition A of Mg is $1.98 \leq A \leq 2.01$. As represented by $Mg_2Si$ or $Mg_2Sn$, the composition A of Mg is 2.00 in terms of the stoichiometric composition ratio. However, some compositional deviations can be allowed in the crystal structure, and crystal structures up to that range can be employed. When the composition A of Mg exceeds the upper limit value, a metallic simple substance of Mg or Mg compound segregates, thereby lowering the thermoelectric performance. This can also be confirmed from FIG. 4 of Patent Document 2 and the like.

Further, in the compound represented by the above general formula (1), the composition X of Si, the composition Y of Sn and the composition Z of Ge satisfy relationships represented by formulas: $0.00 < X \leq 0.25$, $0.60 \leq Y \leq 0.95$, $Z > 0$, $X + Y + Z = 1$ and $-1.00X + 0.40 \geq Z \geq -2.00X + 0.10$ $(0.00 < X \leq 0.25)$, $-1.00Y + 1.00 \geq Z \geq -1.00Y + 0.75$ $(0.60 \leq Y \leq 0.90)$, $-2.00Y + 1.90 \geq Z \geq -1.00Y + 0.75$ $(0.90 < Y \leq 0.95)$.

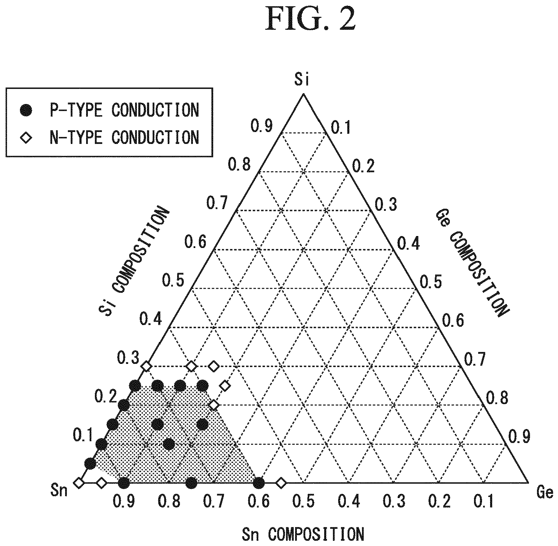

FIG. 2 is a diagram showing composition regions exhibiting p-type conduction and n-type conduction in a quaternary compound of Mg, Si, Sn and Ge. FIG. 3 shows a relationship between the compositions of Ge and Si with respect to the conduction types, and FIG. 4 shows a relationship between the compositions of Ge and Sn with respect to the conduction types.

Such composition regions are thought to occur because the quaternary compound is a solid solution of $Mg_2Si$, $Mg_2Sn$ and $Mg_2Ge$ and is influenced by the conduction type in each solid solution.

It has already been reported that $Mg_2Si$ is n-type, $Mg_2Sn$ is p-type and $Mg_2Ge$ is n-type. For this reason, in the composition region where the Si content is high, it shows n-type conduction under the influence of $Mg_2Si$, whereas in the composition region where the Sn content is high, it shows p-type conduction under the influence of $Mg_2Sn$. In the conventional $Mg_2(Si_{1-x}Sn_x)$ system, its conduction type is determined by the influence of $Mg_2Si$ and $Mg_2Sn$, but Si or Sn is further substituted with Ge in the quaternary system. Therefore, it is likely to exhibit p-type conduction when Si is substituted with Ge, and it is likely to exhibit n-type conduction when Sn is substituted with Ge.

In the thermoelectric material according to one aspect of the present invention, at least any one of the Mg site, the Si site, the Sn site and/or the Ge site of the compound represented by the general formula (1) is substituted with elements selected from the group consisting of alkali metals of group 1A and gold (Au), silver (Ag), copper (Cu), zinc (Zn), calcium (Ca) and gallium (Ga) of group 1B. By replacing at least any one of the Mg site, the Si site, the Sn site and/or the Ge site of the compound with these substitution elements, thermoelectric properties can be enhanced. The element to be substituted is not limited to a single element, and a plurality of elements is substituted.

The substitution site of gallium (Ga) is different from those of alkali metals of group 1A and gold (Au), silver (Ag), copper (Cu), zinc (Zn) and calcium (Ca) of group 1B. Alkali metals of group 1A and gold (Au), silver (Ag), copper (Cu), zinc (Zn) and calcium (Ca) of group 1B substitute for the Mg site, whereas gallium (Ga) substitutes for any one of the Si site, the Sn site or the Ge site.

That is, the composition formula of a compound obtained after replacing Mg in the compound of the composition formula (1) with alkali metals of group 1A and gold (Au), silver (Ag), copper (Cu), zinc (Zn), calcium (Ca) of group 1B is represented by the following composition formula (3):

$$Mg_{A-B}D_B(Si_XSn_YGe_Z) \qquad (3)$$

D is any one or more elements selected from gold (Au), silver (Ag), copper (Cu), zinc (Zn) and calcium (Ca) of group 1B. B is preferably from 0.005 to 0.05.

On the other hand, the composition formula of a compound obtained after replacing any one of the Si site, the Sn site or the Ge site in the compound of the composition formula (1) with Ga is represented by the following composition formula (4):

$$Mg_A(Ga_BSi_SSn_TGe_U) \qquad (4)$$

Here, since any one of the Si site, the Sn site or the Ge site is replaced with Ga, B + S + T + U is 1.0. Also in this case, B is preferably from 0.005 to 0.05.

When the divalent Mg of the compound of the composition formula (1) is substituted with a monovalent alkali metal, Au, Ag or Cu, an electron necessary for the bonding becomes deficient and a hole is supplied. That is, the compound of the composition formula (3) is one in which this hole is supplied to the compound of the composition formula (1), and the electrical resistivity as a semiconductor is reduced. When the electrical resistivity is reduced, the thermoelectric performance is enhanced from the general formula (2). Further, monovalent alkali metals and Ag are preferable because high thermoelectric performance can be realized, and Ag is more preferable because particularly high thermoelectric performance can be realized.

When the divalent Mg of the compound of the composition formula (1) is substituted with Zn and/or Ca, carriers are not introduced because Zn and Ca are divalent. However, it has been confirmed that the compound of the composition formula (3) can enhance the thermoelectric performance, as compared with the compound of the composition formula (1).

It is thought that this is because Zn and Ca elements are metal elements originally having a low electrical resistivity, the thermoelectric performance can be enhanced. Although the Seebeck coefficient does not change since the carrier concentration does not increase, the electrical resistivity can be reduced by the metallic properties and the thermoelectric performance can be enhanced.

The added amount of the element to be substituted is from 5,000 ppm to 50,000 ppm. When these amounts are added, the number of atoms in the composition formula in the $Mg_2Si$ type crystal structure will be from 0.005 to 0.05. In other words, B in the composition formulas (3) and (4) is from 0.005 to 0.05, more preferably from 10,000 ppm to 30,000 ppm, and still more preferably from 20,000 ppm to 30,000 ppm.

If the added amount of the substitution element is too large, the substitution element itself or its compound segregates metallically and it becomes difficult to realize high thermoelectric performance. If the added amount of the substitution element is too small, it is difficult to sufficiently lower the electrical resistivity, and it becomes difficult to realize high thermoelectric performance.

In general, the Si site, the Sn site or the Ge site of the compound of the composition formula (1) are each tetravalent. On the other hand, Ga is capable of adopting a trivalent state. For this reason, the compound of the composition formula (4) in which any one of the Si site, the Sn site and the Ge site of the compound of the composition formula (1) is substituted with Ga has a carrier, can reduce the electrical resistivity, and can enhance the thermoelectric performance.

There is a Seebeck coefficient α as a parameter for enhancing the thermoelectric performance expressed by the general formula (2). The Seebeck coefficient α can be expressed by the following formula (5).
[Equation 1]

$$\alpha = \frac{k_B}{e}\left[\log\left(\frac{N}{n}\right)+C\right] \qquad \cdots \ (5)$$

Here, $k_B$ is the Boltzmann coefficient, e is the electric charge, C is a constant, n is the carrier concentration, and $N$ is expressed by the following formula (6).
[Equation 2]

$$N = \frac{2(2\pi m k_B T)^{\frac{3}{2}}}{h^3} \qquad \cdots (6)$$

Here, $k_B$ is the Boltzmann coefficient, $h$ is the Planck's constant, $T$ is the absolute temperature, and $m$ is the effective mass. That is, the Seebeck coefficient can be expressed as a function of carrier concentration and effective mass.

The p-type thermoelectric material according to one aspect of the present invention is a quaternary compound, and a portion thereof is substituted, so that the effective mass can be increased. Therefore, the p-type thermoelectric material according to one aspect of the present invention can realize not only the improvement of the thermoelectric performance accompanying the reduction of the thermal conductivity and the electrical resistivity but also the improvement of the thermoelectric performance accompanying the increase of the Seebeck coefficient. In other words, a thermoelectric material having high thermoelectric performance can be obtained.

The thermoelectric material according to one aspect of the present invention can be used for, for example, a p-type thermoelectric element (thermoelectric semiconductor) in a thermoelectric conversion device.

(Method for producing p-type thermoelectric material)

A method for producing a p-type thermoelectric material according to one aspect of the present invention includes a step of accommodating magnesium (Mg), silicon (Si), tin (Sn), germanium (Ge) and at least any one of the group consisting of alkali metals of group 1A and gold (Au), silver (Ag), copper (Cu), zinc (Zn), calcium (Ca) and gallium (Ga) of group 1B as a substitution element in a heating member; a step of heating the aforementioned heating member to synthesize a solid solution; and a step of pulverizing and further pressurizing and sintering the aforementioned solid solution. According to this production method, it is possible to produce a thermoelectric material in which any one of the Mg site, the Si site, the Sn site and/or the Ge site of a compound represented by the following general formula (1) composed of magnesium (Mg), silicon (Si), tin (Sn) and germanium (Ge) is substituted with the aforementioned substitution element.

$$Mg_A(Si_X Sn_Y Ge_Z) \qquad (1)$$

provided that relationships represented by formulas: $1.98 \le A \le 2.01$, $0.00 < X \le 0.25$, $0.60 \le Y \le 0.95$, $Z > 0$, $X + Y + Z = 1$ and $-1.00X + 0.40 \ge Z \ge -2.00X + 0.10$ $(0.00 < X \le 0.25)$, $-1.00Y + 1.00 \ge Z \ge -1.00Y + 0.75$ $(0.60 \le Y \le 0.90)$, $-2.00Y + 1.90 \ge Z \ge -1.00Y + 0.75$ $(0.90 < Y \le 0.95)$ are satisfied.

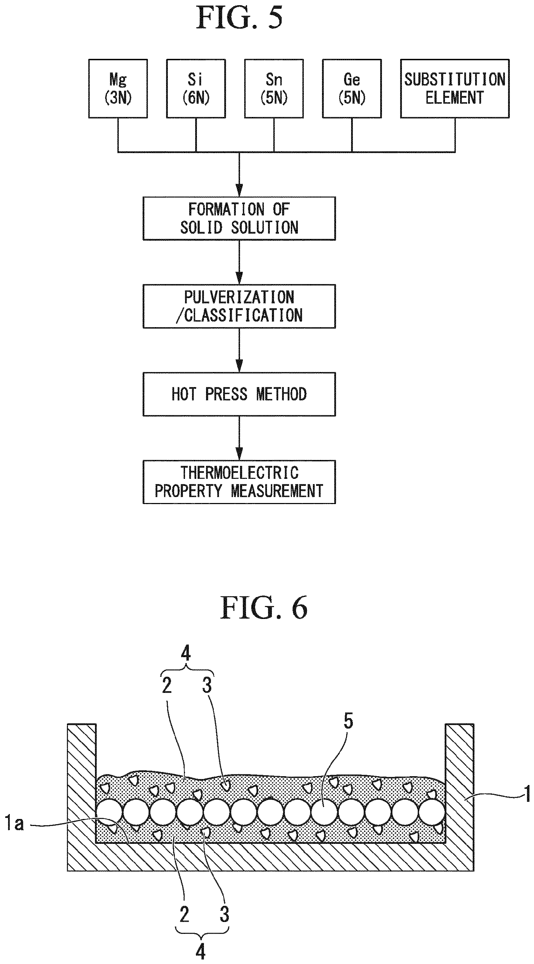

FIG. 5 is a flowchart showing a procedure of the method for producing the p-type thermoelectric material of the present invention.

First, simple substances of Mg, Si, Sn, Ge and substitution elements are weighed so as to satisfy the above composition ranges. At this time, the size of Mg is preferably from 3 to 5 mm If the size is too large, Mg is difficult to melt, and there is a possibility that the simple substance of Mg will remain. If the size is too small, the surface area to be oxidized in the atmosphere increases and the amount of incorporated oxides of Mg increases.

Si and Ge are preferably used in the form of powders or granules, and fine powders of about several tens of micrometers are preferable. Sn is preferably granular, and its average particle diameter can range from, for example, 1 to 3 mm. It is preferable to add the substitution element in a powder form.

When an alkali metal is used as a substitution element, handling is difficult because alkali metals in the form of simple substance are very highly reactive. Therefore, it is preferable to use in the form of a salt of an organic acid (for example, a carboxylic acid). For example, when lithium is used as the alkali metal, it is preferable to use lithium acetate, lithium stearate or the like.

The amounts of Mg, Si, Sn, Ge and substitution elements to be used are determined so that the composition ratio satisfies the aforementioned formula (1).

As shown in FIG. 6, a heating member 1 is prepared. As the heating member 1, a carbon board, a crucible or the like can be used. It is desirable that the heating member 1 be baked in advance.

A mixture 4 composed of a powder mixture 2 consisting of Si, Ge and (a) substitution element(s) and Sn in the form of granules which is denoted with a reference number 3 is evenly spread over a bottom surface 1a of the heating member 1.

Mg in the form of granules which is denoted with a reference number 5 is placed on this mixture 4. The Mg granules 5 are preferably arranged on the mixture 4 at equal intervals.

Next, the mixture 4 is spread evenly thereon.

The heating means 1 and each material contained therein are heated in a heating furnace. By this heating, a solid solution of each element is prepared. As a method of preparing the solid solution, a solid phase reaction method, a liquid-solid phase reaction method, a direct melting method, a mechanical alloying method or the like can be used. In particular, a liquid-solid phase reaction method is preferable. The liquid-solid phase reaction method is a method of promoting a chemical reaction in a state where some elements are in a solid state while the other elements are in a molten state. This method is superior to other methods in that it is a simple synthesis method without composition deviation, incorporation of impurities and dust explosion. In the case of the method for producing a p-type thermoelectric material according to one aspect of the present invention, Sn, Mg, Ge and substitution elements melt to form a liquid, and Si reacts in a solid state.

The heating temperature is preferably 800°C or higher, for example, from 800 to 1,100°C. The heating time can be set, for example, from 1 to 10 hours. With this temperature range, other elements can be melted sufficiently while Si is maintained in a solid state, and segregation of each element or the like can be suppressed. Further, with this heating time, it is possible to allow the reaction to proceed sufficiently.

In order to prevent oxidation of raw materials, heating is preferably performed in a non-oxidizing atmosphere. For example, it is desirable to perform the process in an inert gas atmosphere such as argon (Ar) or in a mixed gas atmosphere in which hydrogen ($H_2$) is mixed with an inert gas.

As a result, an alloy which is a solid solution containing $Mg_2Si$, $Mg_2Sn$, $Mg_2Ge$ and a substitution element is synthesized.

The alloy is then ground. Examples of the grinding means include a hammer mill, a jaw crusher, an impact crusher, a ball mill, an attritor and a jet mill.

It is preferable to classify the obtained powder and to use one having an average particle size within a predetermined range, for example, one having an average particle size of 38 to 75 $\mu$m. As a classification method, there are an air flow classification method, a sieving method and the like.

The average particle size may be, for example, a 50% cumulative particle size in the volume-based particle size distribution. The average particle diameter can be measured by a laser diffraction type particle size analyzer or the like.

Next, this powder is pressed by hot pressing or the like and sintered. For example, the powder can be filled into a die and pressed with a punch.

The temperature condition at the time of sintering is preferably from 600 to 800°C. The pressurization condition (pressing pressure) is preferably from 10 to 100 MPa. The atmosphere during sintering is preferably an inert gas atmosphere such as argon (Ar). The pressurization time can be set, for example, from 1 to 10 hours.

The powder becomes a densified sintered body by pressurization. In addition to the above method, there are a hot isostatic pressing (HIP) process, a plasma sintering (SPS or PAS) method and the like as a sintering method.

The obtained sintered body is a thermoelectric material excellent in characteristics as a p-type thermoelectric material.

The sintered body is cut into a predetermined size depending on the purpose and polished, and then the thermoelectric properties can be measured.

[Examples]

(Example 1 - not according to the invention)

Mg granules (purity: 99.9%), a Si powder (99.9999%), a Sn powder (99.999%), a Ge powder (99.999%) and a Ag powder (99.99%) were prepared as raw materials.

These were weighed in accordance with the composition ratio, arranged in a carbon board and charged into a synthesis furnace to prepare an alloy composed of a solid solution. The alloy composed of the solid solution was prepared by a liquid-solid phase reaction method. The synthesis temperature was 1103 K (830°C), the synthesis time was 4 hours and the reaction atmosphere was a reducing atmosphere of Ar + 3%$H_2$.

Subsequently, the obtained alloy was pulverized and classified so that the particle diameter d was 38 $\mu$m $\leq$ d $\leq$ 75 $\mu$m. The classified powder was sintered by hot pressing to prepare a sintered body. The sintering temperature for the sintered body was 933 K (660°C), the sintering time was 3 hours, the sintering pressure was 50 MPa and the reaction atmosphere was an Ar atmosphere.

According to the procedure described above, a thermoelectric material represented by a composition formula of $Mg_{1.975}Ag_{0.025}(Si_{0.25}Sn_{0.65}Ge_{0.10})$ was obtained. At this time, the amount of Ag added as a substitution element was 25,000 ppm.

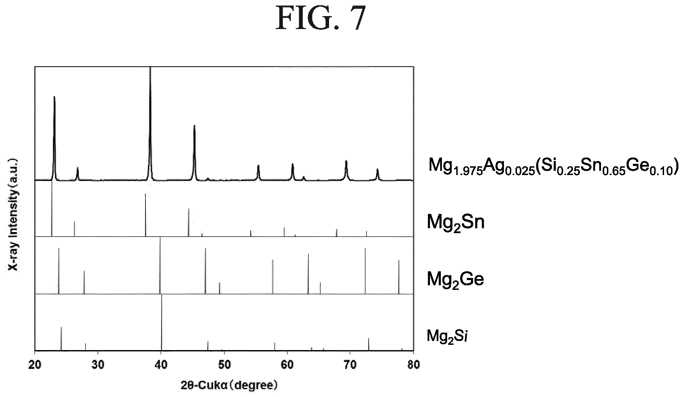

FIG. 7 shows the X-ray diffraction measurement results of the thermoelectric material of Example 1. For the X-ray diffraction measurement, RINT 2500 manufactured by Rigaku Corporation was used. Measurement conditions were set by using Cu-$k_\alpha$ rays so that the tube voltage was 40 kV, the tube current was 300 mA, and 2θ was from 10° to 90°.

The thermoelectric material of Example 1 has an inverse fluorite structure (space group: Fm3m) since its X-ray diffraction profile is located between the X-ray diffraction profiles of $Mg_2Si$ and $Mg_2Sn$ as shown in FIG. 7. Further, it is a single phase of $Mg_2(SiSnGe)$ composition.

(Comparative Example 1)

A thermoelectric material was prepared in the same manner as in Example 1 except that Ge was not added to the raw material. The composition formula of the thermoelectric material was $Mg_{1.975}Ag_{0.025}(Si_{0.25}Sn_{0.75})$. At this time, the amount of Ag added as a substitution element was 25,000 ppm.

(Comparative Example 2)

A thermoelectric material was prepared in the same manner as in Example 1 except that Ag as a substitution element was not added to the raw material. The composition formula of the thermoelectric material was $Mg_{2.00}(Si_{0.25}Sn_{0.65}Ge_{0.10})$.

(Comparative Examples 3 to 6)

They are different from Comparative Example 2 only in that the raw material ratio was changed. The composition formulae of the thermoelectric materials are as follows.

Comparative Example 3: $Mg_{2.00}(Si_{0.15}Sn_{0.75}Ge_{0.10})$
Comparative Example 4: $Mg_{2.00}(Si_{0.30}Sn_{0.60}Ge_{0.10})$
Comparative Example 5: $Mg_{2.00}(Sn_{0.90}Ge_{0.10})$
Comparative Example 6: $Mg_{2.00}(Si_{0.90}Ge_{0.10})$

(Measurement of electrical resistivity)

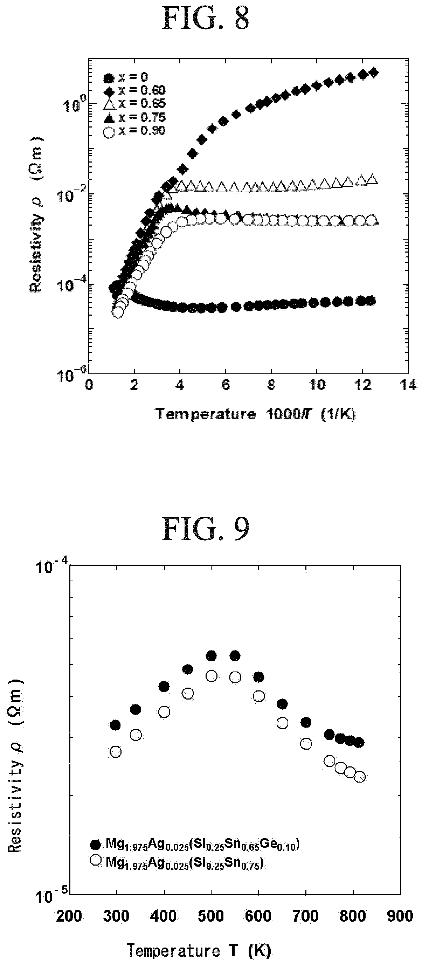

The electrical resistivity of each of Example 1 and Comparative Examples 1 to 6 was measured. The electrical resistivity was measured using the direct current four terminal method. FIG. 8 shows the measurement results of the electrical resistivity of Comparative Examples 2 to 6, and FIG. 9 shows the measurement results of the electrical resistivity of Example 1 and Comparative Example 1. In FIG. 8, x corresponds to the value of x when the thermoelectric materials of Comparative Examples 2 to 6 are expressed by the composition formula $Mg_{2.00}(Si_{0.90-x}Sn_xGe_{0.10})$.
By comparing FIG. 8 with FIG. 9, it is clear that the electrical resistivity is reduced in Example 1 and Comparative Example 1 in which a substitution element has been added.

(Measurement of thermal conductivity)

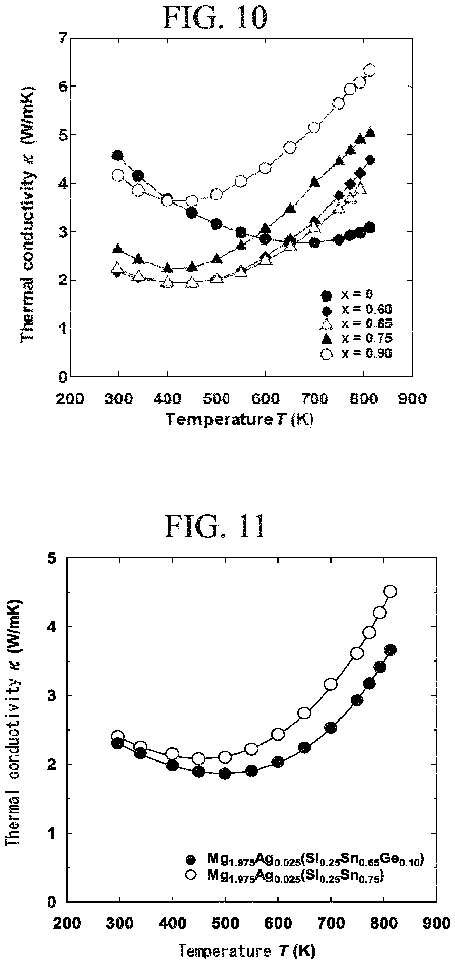

The thermal conductivity of each of Example 1 and Comparative Examples 1 to 6 was measured. The thermal conductivity was measured using a static comparison method with quartz ($\kappa = 1.37$ W/mK). The temperature dependence of thermal conductivity was measured using a laser flash method (ULVAC-RIKO, Inc.; TC-7000). FIG. 10 shows the measurement results of the thermal conductivities of Comparative Examples 2 to 6, and FIG. 11 shows the measurement results of the thermal conductivities of Example 1 and Comparative Example 1. In FIG. 10, x is the same as in FIG. 8.
As shown in FIG. 11, Example 1 shows lower thermal conductivity than that of Comparative Example 1 in the entire temperature range. Further, when comparing the result of Comparative Example 2 (x = 0.65) in FIG. 10 with the result of Example 1 in FIG. 11, there is no great difference in the thermal conductivity. In other words, the thermal conductivity decreases as the thermoelectric material is replaced with one composed of a quaternary compound.

(Measurement of Seebeck coefficient)

The Seebeck coefficient of each of Example 1 and Comparative Examples 1 to 6 was measured. The Seebeck coefficient at room temperature was calculated from the thermoelectromotive force obtained by the temperature difference within 2 K, and the temperature dependence was measured using the large temperature difference method.

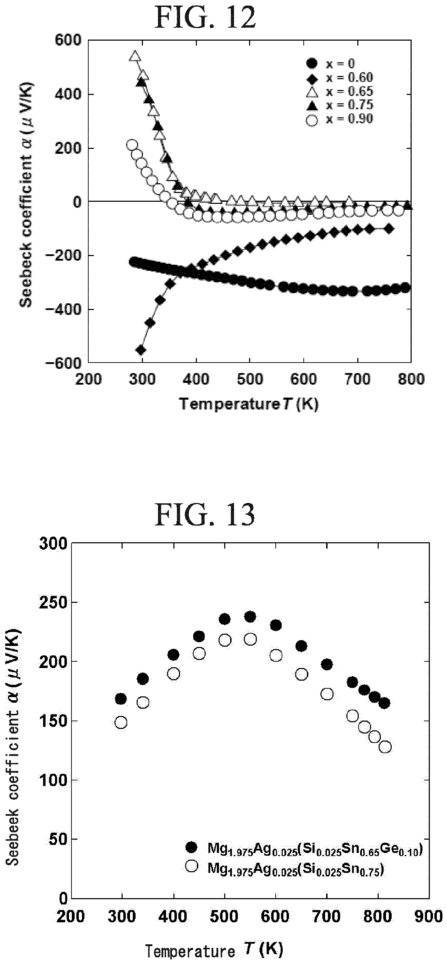

FIG. 12 shows the measurement results of the Seebeck coefficients of Comparative Examples 2 to 6, and FIG. 13 shows the measurement results of the Seebeck coefficients of Example 1 and Comparative Example 1. In FIG. 12, x is the same as in FIG. 8.
By comparing FIG. 12 with FIG. 13, it is clear that the temperature dependence of the Seebeck coefficient greatly differs. As shown in FIG. 12, in Comparative Examples 2 to 6 in which no substitution element has been added, the Seebeck coefficient approaches 0 as the temperature rises. It is thought that this is because as the temperature rises, electrons in the semiconductor forming the thermoelectric material are thermally excited from the valence band to the conduction band, and holes generated as a result of the removal of thermally excited electrons and electrons in the valence band are increased rapidly and form an intrinsic region. Therefore, the thermoelectric materials of Comparative Examples 2 to 6 are reversed from p-type conduction to n-type conduction as the temperature rises. In other words, they cannot function as stable p-type thermoelectric materials.

On the other hand, as shown in FIG. 13, in Example 1 and Comparative Example 1 in which a substitution element has been added, thermoelectric materials of p-type conduction that are also stable with respect to the temperature can be obtained. The thermoelectric material of Example 1 shows a high Seebeck coefficient, as compared with the thermoelectric material of Comparative Example 1.

(Measurement of dimensionless figure of merit)

The dimensionless figure of merit is obtained by multiplying the performance index Z of the thermoelectric material by the absolute temperature and is generally expressed as $ZT$. As indicated by the general formula (2), $ZT$ can be obtained from the thermal conductivity, electrical resistivity, and Seebeck coefficient measured as described above.

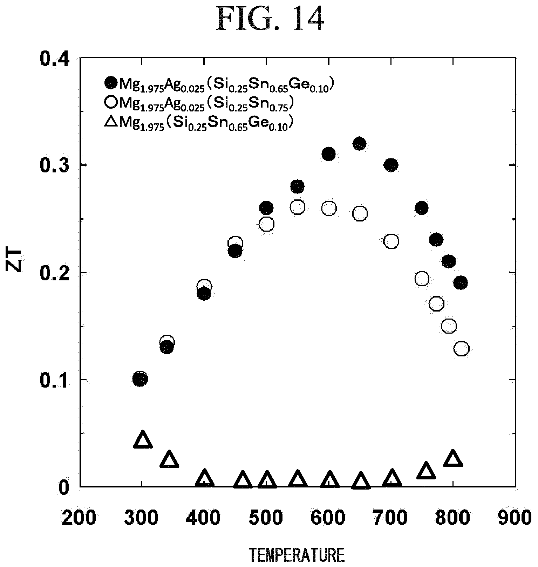

FIG. 14 shows the measurement results of the dimensionless figure of merit $ZT$ of Example 1, Comparative Example 1 and Comparative Example 2.

Example 1 and Comparative Example 1 in which a substitution element has been added show higher thermoelectric performance, as compared with Comparative Example 2. It is considered that although the dimensionless thermoelectric performance is low in Comparative Example 2 because sufficient carriers are not present, in Example 1 and Comparative Example 1, the dimensionless thermoelectric performance is increased due to the decrease in electrical resistivity as carriers are introduced by the substitution. In addition, Example 1 shows higher thermoelectric performance as compared with Comparative Example 1. The maximum value is 0.28 at 650 K in Example 1, whereas it is 0.26 at 550 K in Comparative Example 1. In Example 1, the thermoelectric performance can be improved by 8% as compared with Comparative Example 1.

As described above, in Comparative Examples 2 to 4 in which quaternary compounds are used among Comparative Examples 2 to 6, no significant difference is observed in each measurement result. That is, since substantially the same results are obtained even when the composition ratio is changed, also in Example 1, high thermoelectric performance can be exhibited even if the composition ratio is changed within a predetermined range.

(Example 2 - not according to the invention)

Example 2 is different from Example 1 only in that Ag as a raw material is replaced by Ga.

That is, any one of the Si, Sn and Ge sites in a quaternary composition of $Mg_{2.00}(Si_{0.25}Sn_{0.65}Ge_{0.10})$ was substituted with the added Ga (added amount: 25,000 ppm). The composition formula of the obtained composition is $Mg_{2.00}(Ga_{0.025}Si_{0.25-\beta}Sn_{0.65-\beta}Ge_{0.10-\gamma})$. Here, $\alpha$, $\beta$ and $\gamma$ satisfy the relationships represented as $\alpha \geq 0$, $\beta \geq 0$, $\gamma \geq 0$ and $\alpha + \beta + \gamma = 0.025$.

(Example 3 - not according to the invention)

Example 3 is different from Example 1 in that Li is added as a raw material. That is, the Mg site of the quaternary composition of $Mg_{2.00}(Si_{0.25}Sn_{0.65}Ge_{0.10})$ was substituted with the added Ag (added amount: 20,000 ppm) and Li (added amount: 5,000 ppm). The composition formula of the obtained composition is $Mg_{1.975}Ag_{0.020}Li_{0.005}(Si_{0.25}Sn_{0.65}Ge_{0.10})$.

(Example 4)

Example 4 is different from Example 1 in that Li and Ga are added as raw materials. That is, the Mg site of the quaternary composition of $Mg_{2.00}(Si_{0.25}Sn_{0.65}Ge_{0.10})$ was substituted with the added Ag (added amount: 20,000 ppm) and Li (added amount: 5,000 ppm), and any one of the Si, Sn and Ge sites was substituted with the added Ga (added amount: 25,000 ppm). The composition formula of the obtained composition is $Mg_{1.975}Ag_{0.020}Li_{0.005}(Ga_{0.025}Si_{0.25-\alpha}Sn_{0.65-\beta}Ge_{0.10-\gamma})$. Here, $\alpha$, $\beta$ and $\gamma$ satisfy the relationships represented as $\alpha \geq 0$, $\beta \geq 0$, $\gamma \geq 0$ and $\alpha + \beta + \gamma = 0.025$.

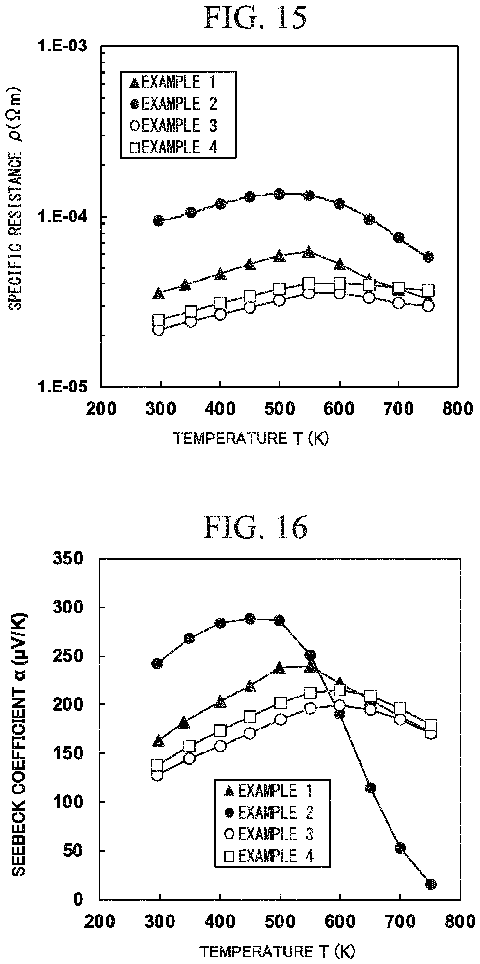

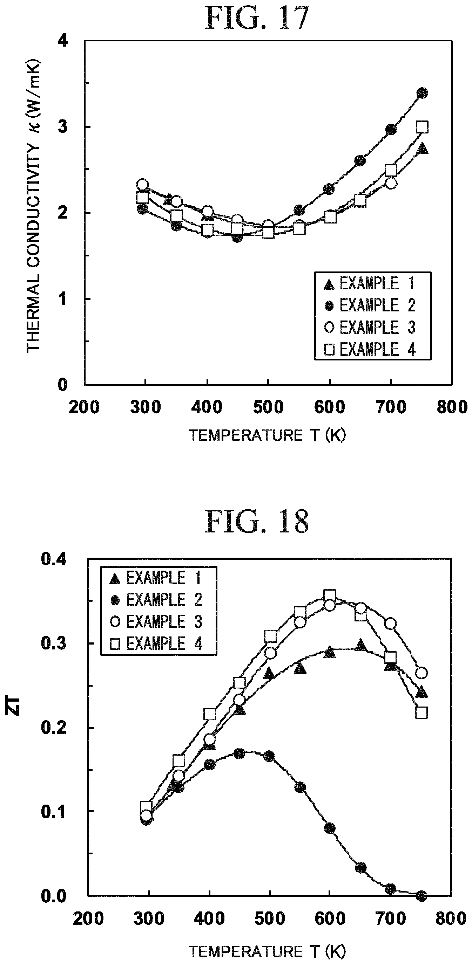

The electrical resistivity, Seebeck coefficient, thermal conductivity, and dimensionless figure of merit ($ZT$) of Examples 1 to 4 were measured by the same means as described above. The measured results are shown in FIGS. 15 to 18.

From the results of FIG. 15 to FIG. 18, it can be confirmed that the p-type performance is exhibited in any of Examples 1 to 4. In addition, Examples 3 and 4 in which the Mg site was replaced with two or more added elements show better thermoelectric properties as compared to those of Examples 1 and 2. It is thought that this is because the uniformity of the thermoelectric material was enhanced by adding two or more elements. It is thought that as the number of added elements increases, as compared with the case where only one element is added, the segregation of elements is reduced and the uniformity increases.

[Reference Signs List]

1: Heating member; 1a: Bottom surface; 2: Powder mixture; 3: Sn; 4: Mixture; 5: Mg

**Claims**

**1.**  A p-type thermoelectric material,
wherein at least any one of a Mg site, a Si site, a Sn site and/or a Ge site of a quaternary compound represented by the following general formula (1) which is composed of magnesium, silicon, tin and germanium is substituted with any one or more elements selected from the group consisting of alkali metals of group 1A and gold, silver, copper, zinc, calcium and gallium of group 1B:

$$Mg_A(Si_XSn_YGe_Z) \qquad (1)$$

provided that relationships represented by formulas:

$$1.98 \le A \le 2.01,$$

$$0.00 < X \le 0.25,\ 0.60 \le Y \le 0.95,\ Z > 0,\ X + Y + Z = 1,$$

and

in the case where X satisfies $0.00 < X \le 0.25$, Z satisfies $-1.00X + 0.40 \ge Z \ge -2.00X + 0.10$,
in the case where Y satisfies $0.60 \le Y \le 0.90$, Z satisfies $-1.00Y + 1.00 \ge Z \ge -1.00Y + 0.75$,
in the case where Y satisfies $0.90 < Y \le 0.95$, Z satisfies $-2.00Y + 1.90 \ge Z \ge -1.00Y + 0.75$,
wherein the quaternary compound has an inverse fluorite structure with space group Fm3m,
wherein an element to be substituted is added at 5,000 ppm to 50,000 ppm,
wherein in a case where the element to be substituted is any one or more elements selected from alkali metals of group 1A and gold, silver, copper, zinc and calcium of group 1B, the Mg site is substituted; and
wherein in a case where the element to be substituted is gallium, any one of the Si site, the Sn site, and the Ge site is substituted, and
wherein the quaternary compound represented by said general formula (1) is multiply substituted with silver, an alkali metal of group 1A and one or more of gold, copper, zinc, calcium and gallium of group 1B.

**2.**  A thermoelectric element comprising the p-type thermoelectric material according to Claim 1.

**3.**  A method for producing a p-type thermoelectric material of claim 1, the method comprising:

a step of weighing and accommodating magnesium (Mg), silicon (Si), tin (Sn), germanium (Ge), silver (Ag), an alkali metal of group 1A and one or more of gold (Au), copper (Cu), zinc (Zn), calcium (Ca) and gallium (Ga) of group 1B in a heating member;
a step of heating said heating member to synthesize a solid solution; and
a step of pulverizing and further pressurizing and sintering said solid solution.

**Patentansprüche**

**1.**  Ein thermoelektrisches Material vom p-Typ,
wobei mindestens eine Mg-Stelle, eine Si-Stelle, eine Sn-Stelle und / oder eine GeStelle in einer quaternären Verbindung, dargestellt mit der folgenden allgemeinen Formel (1), bestehend aus Magnesium, Silizium, Zinn und Germanium mit einem oder mehreren Elementen substituiert wird, die aus der Gruppe, bestehend aus Alkalimetallen der Gruppe 1A sowie Gold, Silber, Kupfer, Zink, Kalzium und Gallium aus der Gruppe 1B ausgewählt werden:

$$Mg_A(Si_xSn_yGe_z) \qquad (1)$$

vorausgesetzt, dass die Beziehungen, dargestellt durch die Formeln:

$$1.98 \leq A \leq 2.01,$$

$$0.00 < X \leq 0.25, \ 0.60 \leq Y \leq 0.95, \ Z > 0, \ X + Y + Z = 1,$$

und

für den Fall, dass X $0.00 < X \leq 0.25$ erfüllt, erfüllt Z $-1.00X + 0.40 \geq Z \geq -2.00X + 0.10$,
für den Fall, dass Y $0.60 \leq Y \leq 0.90$ erfüllt, erfüllt Z $-1.00Y + 1.00 \geq Z \geq -1.00Y + 0.75$,
für den Fall, dass Y $0.90 < Y \leq 0.95$ erfüllt, erfüllt Z $-2.00Y + 1.90 \geq Z \geq -2 \ 0 \ 1.00Y + 0.75$,
wobei die quaternäre Verbindung eine inverse Fluorit-Struktur aufweist, mit Raumgruppe Fm3m,
wobei ein zu substituierendes Element mit 5.000 ppm bis 50.000 ppm hinzugefügt wird,
wobei in dem Fall, dass es sich bei dem zu substituierenden Element um eines oder mehr Elemente handelt, die ausgewählt werden aus den Alkalimetallen der Gruppe 1A sowie Gold, Silber, Kupfer, Zink und Kalzium aus der Gruppe 1B, die Mg- Stelle substituiert wird; und
wobei für den Fall, dass es sich bei dem zu substituierenden Element um Gallium handelt, eine beliebige der Si- Stelle, Sn- Stelle und Ge- Stelle substitutiert wird, und
wobei die quaternäre Verbindung, dargestellt durch die genannte allgemeine Formel (1) mehrfach substituiert wird mit Silber, einem Alkalimetall der Gruppe 1A und einem oder mehrere Elementen wie Gold, Kupfer, Zink, Kalzium und Gallium der Gruppe IB.

2. Ein thermoelektrisches Element, das das thermoelektrische Material vom p-Typ nach Anspruch 1 enthält.

3. Ein Verfahren zur Herstellung des thermoelektrischen Materials vom p-Typ nach Anspruch 1, wobei dieses Verfahren umfasst:

einen Schritt des Wiegens und der Aufnahme von Magnesium (Mg), Silizium (Si), Zinn (Sn), Germanium (Ge), Silber (Ag), einem Alkalimetallen der Gruppe 1A und eines oder mehrerer Elemente wie Gold (Au), Kupfer (Cu), Zink (Zn), Kalzium (Ca) und Gallium (Ga) aus der Gruppe 1B in einem Heizelement;
ein Schritt des Erhitzens des genannten Heizelementes zum Synthetisieren einer festen Lösung; und
ein Schritt des Pulverisierens und weiteren Pressens und Sinterns dieser festen Lösung.

**Revendications**

1. Matériau thermoélectrique de type p,
dans lequel au moins l'un quelconque parmi un site de Mg, un site de Si, un site de Sn et/ou un site de Ge d'un composé quaternaire, représenté par la formule générale suivante (1), qui est composé de magnésium, de silicium, d'étain et de germanium, est remplacé par l'un quelconque ou par plusieurs élément(s) sélectionné(s) dans le groupe comprenant des métaux alcalins du groupe 1A et l'or, l'argent, le cuivre, le zinc, le calcium et le gallium du groupe 1B:

$$Mg_A(Si_XSn_YGe_Z) \qquad (1)$$

pourvu que les relations représentées par les formules:

$$1{,}98 \leq A \leq 2{,}01,$$

$$0{,}00 < X \leq 0{,}25, \ 0{,}60 \leq Y \leq 0{,}95, \ Z > 0, \ X + Y + Z = 1,$$

et

dans le cas où X satisfait 0,00 < X ≤ 0,25,
Z satisfait -1,00X + 0,40 ≥ Z ≥ -2,00X + 0,10,
dans le cas où Y satisfait 0,60 ≤ Y ≤ 0,90,
Z satisfait -1,00Y + 1,00 ≥ Z ≥ -1,00Y + 0,75,
dans le cas où Y satisfait 0,90 < Y ≤ 0,95,
Z satisfait -2,00Y + 1,90 ≥ Z ≥ -1,00Y + 0,75,
dans lequel le composé quaternaire présente une structure de fluorine inversée avec un groupe d'espace Fm3m,
dans lequel un élément à remplacer est ajouté en une quantité comprise entre 5000 ppm et 50000 ppm,
dans lequel, dans le cas où l'élément à remplacer est l'un quelconque ou plusieurs élément(s) sélectionné(s) parmi des métaux alcalins du groupe 1A et l'or, l'argent, le cuivre, le zinc et le calcium du groupe 1B, le site de Mg est remplacé; et
dans lequel, dans le cas où l'élément à remplacer est le gallium, l'un quelconque parmi le site de Si, le site de Sn et le site de Ge est remplacé, et
dans lequel le composé quaternaire représenté par ladite formule générale (1) est multiplement remplacé par l'argent, un métal alcalin du groupe 1A et un ou plusieurs élément(s) parmi l'or, le cuivre, le zinc, le calcium et le gallium du groupe 1B.

2.  Elément thermoélectrique comprenant le matériau thermoélectrique de type p selon la revendication 1.

3.  Procédé de production d'un matériau thermoélectrique de type p, le procédé comprenant:

une étape de pesage et d'introduction dans un élément chauffant de magnésium (Mg), de silicium (Si), d'étain (Sn), de germanium (Ge), d'argent (Ag), d'un métal alcalin du groupe 1A et d'un ou de plusieurs élément(s) parmi l'or (Au), le cuivre (Cu), le zinc (Zn), le calcium (Ca) et le gallium (Ga) du groupe 1B,
une étape de chauffage dudit élément chauffant dans le but de synthétiser une solution solide; et
une étape de pulvérisation ainsi que de pressurage et de frittage supplémentaires de ladite solution solide.

# FIG. 1

# FIG. 2

# FIG. 3

# FIG. 4

# FIG. 5

# FIG. 6

# FIG. 7

$Mg_{1.975}Ag_{0.025}(Si_{0.25}Sn_{0.65}Ge_{0.10})$

$Mg_2Sn$

$Mg_2Ge$

$Mg_2Si$

X-ray Intensity(a.u.)

$2\theta$-Cuk$\alpha$(degree)

# FIG. 8

# FIG. 9

# FIG. 10

# FIG. 11

## FIG. 12

## FIG. 13

# FIG. 14

## FIG. 15

## FIG. 16

## FIG. 17

## FIG. 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005133202 A
- JP 5274146 B
- JP 2011151329 A

**Non-patent literature cited in the description**

- **TADA et al.** Preparation and thermoelectric properties of Mg2Si0.9-xSnxGe. *PHYSICA STATUS SOLIDI. C,* 2013, vol. 10 (12), 1704-1707
- **Y.ISODA et al.** hermoelectric Properties of p-Type Mg2.00Si0.25Sn0.75 with Li and Ag Double Doping. *Journal of ELECTRONIC MATERIALS,* 2010, vol. 39 (9), 1531-1535
- **GUANGYU JIANG et al.** Improving p-type thermoelectric performance of Mg2(Ge,Sn) compounds via solid solution and Ag doping. *Intermetallics,* 2013, vol. 32, 312-317